# FASCICULE DE BREVET EUROPEEN

(11) **EP 4 189 734 B1**
(45) Date de publication et mention de la délivrance du brevet: **26.06.2024**
(21) Numéro de dépôt: 21740160.3
(22) Date de dépôt: 23.06.2021
(51) Int. Cl.: H01L 21/762, H01L 21/02, H01L 21/3105

(54) **PROCEDE DE REPORT D'UNE COUCHE MINCE SUR UN SUBSTRAT SUPPORT MUNI D'UNE COUCHE DE PIEGEAGE DE CHARGES**
VERFAHREN ZUM ÜBERTRAGEN EINER DÜNNEN SCHICHT AUF EIN TRÄGERSUBSTRAT MIT LADUNGSEINFANGSCHICHT
METHOD FOR TRANSFERRING A THIN LAYER ONTO A SUPPORT SUBSTRATE PROVIDED WITH A CHARGE TRAPPING LAYER

(30) Priorité: 28.07.2020 FR 2007952; 30.03.2021 FR 2103274
(43) Date de publication de la demande: 07.06.2023
(73) Titulaire: SOITEC, 38190 Bernin (FR)
(72) Inventeur: CLEMENCEAU, Bruno, 38190 Bernin (FR); ECARNOT, Ludovic, 38190 Bernin (FR); GHORBEL, Aymen, 38190 Bernin (FR); BROEKAART, Marcel, 38190 Bernin (FR); DELPRAT, Daniel, 38190 Bernin (FR); ROUCHIER, Séverin, 38190 Bernin (FR); THIEFFRY, Stéphane, 38190 Bernin (FR); DURET, Carine, 38190 Bernin (FR)
(74) Mandataire: IP Trust
(86) Numéro de dépôt international: PCT/FR2021/051140
(87) Numéro de publication internationale: WO 2022/023630

(56) Documents cités:
- US-A1- 2020 020 520
- PYE J T ET AL: "HIGH-DENSITY PLASMA CVD AND CMP FOR 0.25- M INTERMETAL DIELECTRIC PROCESSING", SOLID STATE TECHNOLOGY, PENNWELL CORPORATION, TULSA, OK, US, vol. 38, no. 12, 1 décembre 1995 (1995-12-01), XP000542745, ISSN: 0038-111X
- MACHIDA K ET AL: "NEW PLANARIZATION TECHNOLOGY USING BIAS-ECR PLASMA DEPOSITION", JAPANESE JOURNAL OF APPLIED PHYSICS, JAPAN SOCIETY OF APPLIED PHYSICS, JP, 25 août 1985 (1985-08-25), pages 329-332, XP000835880, ISSN: 0021-4922

## Description

### DOMAINE DE L'INVENTION

La présente invention concerne un procédé de report d'une couche mince sur un substrat support comprenant une couche de piégeage de charges. Ces substrats trouvent une application notable dans le domaine des dispositifs intégrés radiofréquences, c'est-à-dire des dispositifs électroniques traitant des signaux dont la fréquence est comprise entre environ 3kHz et 300GHz, par exemple dans le domaine des télécommunications (téléphonie, Wi-Fi, Bluetooth...) . Ces substrats trouvent également leur application dans le domaine de la photonique.

### ARRIERE PLAN TECHNOLOGIQUE DE L'INVENTION

Pour se prémunir ou limiter le phénomène de couplage électromagnétique qui peut se produire entre un dispositif électronique ou photonique et le substrat support d'un substrat de silicium sur isolant (SOI) sur lequel ce dispositif est formé, il est connu d'insérer entre la couche diélectrique enterrée et le support du SOI, directement sous la couche diélectrique, une couche de piégeage de charges. Cette couche peut être constituée par exemple d'une couche de 1 à 10 microns de silicium polycristallin. Les joints des grains formant le poly cristal constituent alors des pièges pour les porteurs de charges, ceux-ci pouvant provenir de la couche de piégeage elle-même ou du substrat sous-jacent. De la sorte, on prévient l'apparition d'un plan conducteur sous l'isolant. La fabrication de ce type de substrat SOI bien connu est par exemple décrite dans les documents FR2860341, FR2933233, FR2953640, US2015115480, US7268060, US6544656, US20200020520 ou WO2020008116.

Pour former un substrat SOI présentant une telle couche de piégeage, on prépare un substrat support en formant une couche de piégeage de charges sur un substrat de base. Puis, on reporte une couche mince sur ce substrat support par l'intermédiaire d'un procédé de transfert de couche, par exemple selon la technologie Smart Cut^{®}. Selon cette technologie, on assemble, typiquement par adhésion moléculaire, un substrat donneur au substrat support, le substrat donneur présentant un plan de fragilisation définissant, avec sa face exposée, la couche mince à reporter. On fracture ensuite le substrat donneur au niveau du plan de fragilisation pour reporter la couche mince sur le substrat support. La couche diélectrique est insérée entre le substrat support et la couche mince, par exemple par oxydation de l'un et/ou de l'autre de ces substrats, avant leur assemblage.

Dans la technologie Smart Cut^{®}, le plan de fragilisation est obtenu en introduisant des espèces légères (hydrogène et/ou hélium par exemple) dans le substrat donneur, à travers la couche diélectrique lorsque celle-ci est présente, généralement par implantation. L'épaisseur de la couche mince à transférer dicte l'énergie et la dose des espèces à implanter : plus cette épaisseur est importante et plus l'énergie et la dose sont également importantes. Implanter une forte dose à haute énergie n'est pas industriellement favorable aussi, pour contourner ce problème, il est préférable de former une partie au moins de la couche de diélectrique sur le substrat support plutôt que sur le substrat donneur, notamment lorsque cette couche diélectrique est choisie relativement épaisse, par exemple supérieure à 200nm. Dans le domaine de la photonique, cette épaisseur peut atteindre un micron, voire plusieurs microns, ce qui exacerbe tous les problèmes liés à la présence d'couche diélectrique de forte épaisseur.

Les expériences menées par la demanderesse ont ainsi révélé que la formation d'une couche diélectrique par oxydation d'une couche de piégeage de charge en silicium polycristallin posait de nombreux problèmes. Cette oxydation tend à former un substrat support présentant un état de surface rugueux, qu'il faut donc préparer avant l'étape d'assemblage, par exemple par polissage, ce qui complexifie le procédé. L'interface enterrée entre l'oxyde de silicium et le reste de la couche de poly silicium est également rugueuse, ce qui peut poser des problèmes d'inspection optique du substrat SOI lors des étapes de fabrication des dispositifs. On note à ce propos que cette interface n'est pas accessible pour un polissage, et est nécessairement conservée dans le corps du substrat, ce qui peut affecter le bon fonctionnement d'un dispositif formé dans/sur un substrat employant un tel substrat support, en particulier un dispositif photonique. De plus, l'étape d'oxydation tend à déformer le substrat support et à faire apparaître une courbure importante (désignée par le terme anglais "bow" dans la technologie de semi-conducteurs). La présence d'une telle courbure rend délicate l'étape suivante d'assemblage, et plus généralement la manipulation du substrat support dans la ligne de production par des équipements conventionnels.

On note que la formation de la couche de diélectrique par dépôt sur le substrat support plutôt que par oxydation du support présente des problèmes similaires. En effet, les techniques conventionnelles de dépôt PECVD (acronyme de l'expression anglo-saxonne « Plasma Enhanced Chemical Vapor Déposition » ou dépôt chimique en phase vapeur assisté par plasma) ou LPCVD (acronyme de l'expression anglo-saxonne « Low Pressure Chemical Vapor Déposition » ou dépôt chimique en phase vapeur à pression sous atmosphérique) génèrent des courbures importantes et conduisent généralement à former des couches très rugueuses qu'il faut préparer par polissage avant de pouvoir envisager tout assemblage.

On connaît des documents « High density plasma CVD and CMP for 0.25 M intermetal dielectric processing » de Pye et al, Solid State Technology, Penwell corporation, vol 38, n°12, 1995 et de « New planarization technology using bias ECR plasma déposition" de Machida et al, Japanese journal of applied physics, pages 329-332 (1985) des techniques de dépôt de films diélectriques intermétalliques que l'on retrouve généralement entre deux niveaux de métaux d'une structure semi-conductrice fonctionnelle. Ces films visent à reboucher des motifs topographiques présentant un facteur de forme important, et leur dépôt est suivi d'une étape de polissage.

### OBJET DE L'INVENTION

La présente invention vise à pallier tout ou partie des inconvénients précités.

### BREVE DESCRIPTION DE L'INVENTION

En vue de la réalisation de l'un de ces buts, l'objet de l'invention propose procédé de report d'une couche mince sur un substrat support comprenant les étapes suivantes :
- préparer un substrat support à l'aide d'un procédé de préparation comprenant la fourniture d'un substrat de base présentant, sur une face principale, une couche de piégeage de charges et la formation d'une couche diélectrique présentant une épaisseur supérieure à 200nm sur la couche de piégeage de charges, la formation de la couche diélectrique mettant simultanément en oeuvre le dépôt et la pulvérisation ionique de la couche diélectrique ;
- assembler, par adhésion moléculaire et sans préparer la face libre de la couche diélectrique par polissage, un substrat donneur à la couche diélectrique du substrat support, le substrat donneur présentant un plan de fragilisation définissant la couche mince ;
- fracturer le substrat donneur au niveau du plan de fragilisation pour libérer la couche mince et la reporter sur le substrat support.

Selon d'autres caractéristiques avantageuses et non limitatives de l'invention, prises seules ou selon toute combinaison techniquement réalisable :
- le procédé de préparation comprend la formation d'une couche de compensation de courbure sur une face arrière du substrat de base, opposée à la face principale ;
- la couche de compensation de courbure présente une épaisseur comprise entre 500 nm et 1000nm ;
- le substrat de base est un substrat de silicium monocristallin présentant une résistivité inférieure à 1000 ohm.cm ;
- le substrat de base est un substrat de silicium monocristallin présentant une résistivité supérieure à 600 ohm.cm ;
- la couche de piégeage de charges comprend du silicium polycristallin ;
- la couche de piégeage de charges comprend du carbone ;
- la couche de piégeage de charges présente une épaisseur comprise entre 1 micron et 20 microns ;
- la couche diélectrique est constituée d'oxyde de silicium ;
- la couche diélectrique comprend une couche barrière en nitrure de silicium ou en oxynitrure de silicium ;
- la couche diélectrique présente une épaisseur comprise entre 200nm et 10 microns, et préférentiellement entre 600nm et 10 microns ;
- le ratio dépôt/pulvérisation est compris entre 1 et 10, préférentiellement entre 2 et 5 ;
- la couche diélectrique est formée à une température comprise entre 300°C et 450°C, préférentiellement entre 350°C et 400°C.
- la couche diélectrique est formée dans une atmosphère présentant une pression inférieure à la pression atmosphérique ;
- le procédé comprend en outre un recuit de la couche diélectrique dans une atmosphère neutre et à une température excédant la température de formation de la couche diélectrique, préférentiellement inférieure à 950°C ;
- la face libre de la couche diélectrique présente une rugosité inférieure à 0,5 nm en valeur quadratique moyenne sur un champ de mesure de 10 microns par 10 microns ;
- le substrat donneur est dépourvu de toute couche superficielle diélectrique.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente un substrat support d'un procédé de transfert de couche conforme à l'invention ;
- La figure 2 représente un substrat final obtenu à l'issue d'un procédé de transfert de couche conforme à l'invention ;
- Les figures 3A à 3E représentent un mode de réalisation d'un substrat support ;
- La figure 4 représente un substrat final obtenu à l'issue d'un procédé de transfert de couche d'un mode de réalisation.

### DESCRIPTION DETAILLEE DE L'INVENTION

### Présentation du substrat final

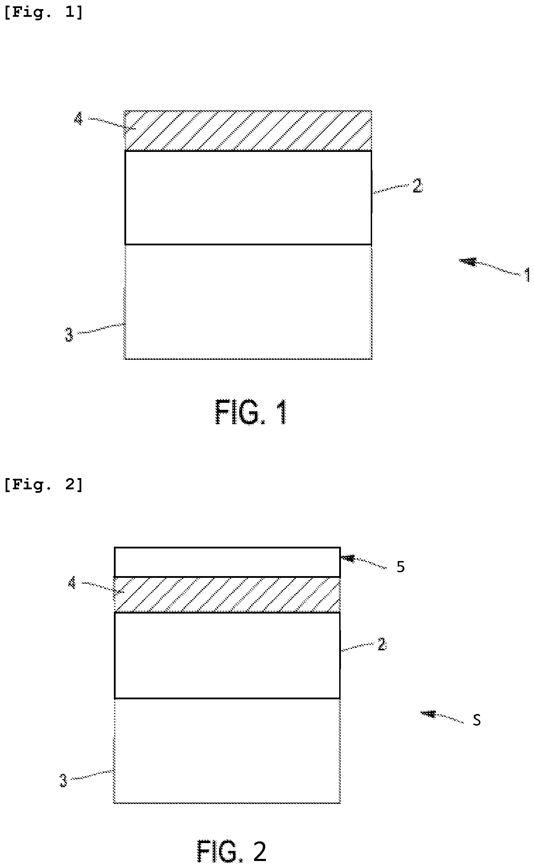

En référence à la figure 2, un substrat final S d'un mode de réalisation comprend un substrat de base 3, une couche de piégeage de charge 2 disposée sur le substrat de base 3, une couche diélectrique 4 disposée sur et directement en contact avec la couche de piégeage de charges 2 et une couche mince 5 disposée sur la couche diélectrique 4. Le substrat de base 3 muni de la couche de piégeage de charges et de la couche diélectrique 4 forme un substrat support 1 du substrat final S.

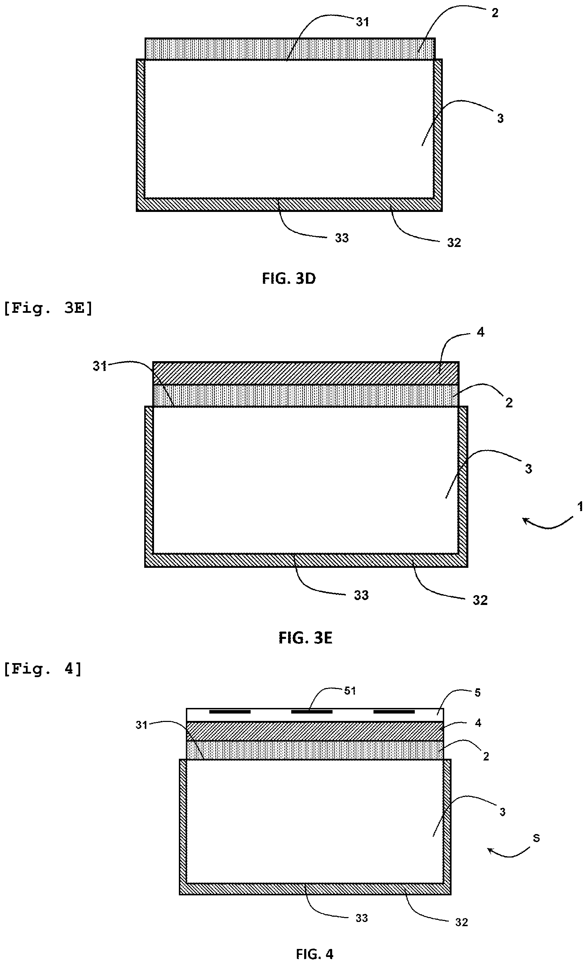

Dans le mode de réalisation illustré à la figure 4, le substrat support 1 du substrat final S comporte un substrat de base 3 muni d'une couche de piégeage de charges 2 et d'une couche de compensation de courbure 32. Cette couche a pour fonction de générer une déformation du substrat de base 3, qui servira notamment à compenser au moins partiellement les déformations futures que le substrat de base 3 et le substrat final S subiront au cours des différentes étapes du procédé qui forme l'objet principal de cette description. Il s'agit notamment de compenser les contraintes apportées par la couche diélectrique 4 et dans une moindre mesure par la couche de piégeage de charges 2, lorsque celles-ci sont formées sur le substrat de base 3.

La couche de piégeage de charges 2 est disposée sur une face principale 31 du substrat de base 3, et la couche de compensation 32 est disposée sur une face arrière 33 du substrat de base 3, cette face arrière 33 étant opposée à la face principale 31. Préférentiellement, la couche de compensation 32 est en oxyde de silicium ou en nitrure de silicium. Elle présente une épaisseur supérieure à 200 nm, et de manière plus préférentielle une épaisseur comprise entre 500 et 1000 nm.

Le substrat final S (et donc le substrat support 1) des modes de réalisation des figures 2 et 4 peut prendre la forme d'une plaquette, circulaire, de dimension normalisée, par exemple de 200 mm ou 300 mm, voire 450 mm de diamètre. C'est notamment le cas lorsque le substrat final S, et en particulier la couche mince 5, est encore vierge de tout dispositif. Mais l'invention n'est nullement limitée à ces dimensions ou à cette forme.

Le substrat de base 3 présente une épaisseur de plusieurs centaines de microns. Préférentiellement, le substrat de base 3 présente une résistivité élevée, supérieure à 100 ou 1000 ohms.cm, et plus préférentiellement encore supérieure à 3000 ohms.cm. On limite de la sorte la densité des charges, trous ou électrons, qui sont susceptibles de se déplacer dans le substrat de base 3, et donc détériorer la performance RF du substrat final S. Mais l'invention n'est pas limitée à un substrat de base 3 présentant une telle résistivité, et elle procure également des avantages de performance RF lorsque le substrat de base 3 présente une résistivité plus conforme, inférieure à 1000 ohms.cm, de l'ordre de quelques centaines d'ohms.cm, ou 100 ohms.cm ou moins.

Pour des raisons de disponibilité et de coût, le substrat de base 3 est préférentiellement en silicium, et notamment en silicium monocristallin. Il peut s'agir par exemple d'un substrat CZ à faible teneur en oxygène interstitiel qui présente, comme cela est bien connu en soi, une résistivité qui peut être supérieure à 1000 ohms.cm. Le substrat de base 3 peut alternativement être formé d'un autre matériau : il peut s'agir par exemple de saphir, de carbure de silicium, de silicium-germanium, matériaux III-V, de verre... Il peut s'agir alternativement encore d'un substrat CZ monocristallin plus standard, dont la résistivité est inférieure à 1000 ohms.cm, ou encore d'un substrat CZ à forte, ou moyenne teneur en oxygène interstitiel, pouvant être dopé n ou p et qui présente une résistivité qui peut être de l'ordre de 500 ohms.cm ou moins.

Le substrat support 1 des différents modes de réalisation de l'invention peut optionnellement comporter, disposé sur, et directement en contact avec, le substrat de base 3, une fine couche diélectrique, par exemple en dioxyde de silicium ou en nitrure de silicium. La fine couche diélectrique (non représentée sur les figures 1 et 2) présente une épaisseur supérieure à quelques nm, par exemple comprise entre 5 nm et 500 nm. Elle peut être obtenue par oxydation du substrat de base 3 ou par dépôt sur ce substrat. Pour limiter la durée et le coût de la formation de cette fine couche, on peut choisir son épaisseur pour qu'elle soit comprise entre 5 nm et 200 nm, comme par exemple 145 nm. La fine couche diélectrique permet d'éviter ou de limiter la recristallisation de la couche de piégeage de charge 3, lorsque le substrat support 1 ou le substrat final S est exposé à une température élevée.

Le substrat support 1 comporte également une couche de piégeage de charges 2, disposée sur et directement en contact avec le substrat de base 3 (ou avec la fine couche diélectrique lorsque celle-ci est présente). La couche de piégeage 2 présente une résistivité supérieure à 500 ohm.cm et préférentiellement à 1000 ohm.cm, et encore plus préférentiellement supérieure à 10 kohm.cm. Comme cela a été évoqué en introduction de la présente demande, la couche de piégeage a pour fonction de piéger les porteurs de charges pouvant être présents dans le support 1 et de limiter leur mobilité. C'est notamment le cas lorsque le substrat final S comprend une structure semi-conductrice émettant un champ électromagnétique pénétrant dans le substrat support 1, et donc susceptible d'interagir et rendre mobiles ces charges. La couche de piégeage de charges 2 présente une épaisseur typiquement comprise entre 1 micron et 15 microns, voire même 20 microns.

La couche de piégeage 2 peut, d'une manière générale, être constituée d'une couche semi-conductrice non monocristalline présentant des défauts structurels tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans la couche de piégeage qui présente en conséquence une résistivité élevée.

Pour les mêmes raisons de disponibilité et de coût qui ont déjà été évoquées, la couche de piégeage 2 est préférentiellement en silicium polycristallin. Mais elle peut être constituée ou comprendre un autre matériau semi-conducteur et polycristallin. On peut bien entendu prévoir de former cette couche de piégeage de charges 2 par d'autre technique que celle prévoyant une couche formée de silicium polycristallin. Cette couche peut également comprendre du carbone ou être constituée ou comprendre du carbure de silicium ou un alliage de silicium et de carbone, par exemple sous la forme de couches intercalaires insérées dans une épaisseur de silicium polycristallin. Lorsque la couche de piégeage 2 est constituée par du carbure de silicium ou un alliage de silicium et de carbone, son épaisseur est préférentiellement comprise entre quelques nm (par exemple 2 nm) à quelques dizaines de nm (par exemple 50nm). Il peut alternativement s'agir de réaliser les pièges électriques dans la couche 2 par bombardement ionique d'espèces relativement lourdes (par exemple de l'argon) dans une partie superficielle du substrat de base 3 afin d'y créer des défauts cristallins aptes à piéger des charges électriques. On peut également prévoir une couche de piégeage de charges 2 formée d'une matière poreuse, par exemple par porosification d'une partie superficielle du substrat de base 3 lorsque celui-ci est en silicium.

En tout état de cause, la couche de piégeage 2 présente une résistivité élevée supérieure à 500 ohm.cm. À cette fin, la couche de piégeage 2 n'est pas intentionnellement dopée, c'est-à-dire qu'elle présente une concentration en dopant porteur de charges inférieure à 10 E14 atomes par centimètre cube. Elle peut être riche en azote ou en carbone afin d'améliorer sa caractéristique de résistivité.

Revenant à la description générale des figures 1 et 4, le substrat support 1 comprend également une couche diélectrique 4 directement disposée sur la couche de piégeage 2. A titre d'exemple, la couche diélectrique 4 peut être constituée ou comprendre du dioxyde de silicium ou du nitrure de silicium. Il peut également s'agir d'un empilement de ces matériaux. L'épaisseur de la couche diélectrique 4 peut être comprise entre 10nm et 10 microns, mais dans le cadre de la présente description, cette couche présente une épaisseur relativement importante, par exemple supérieure à 200nm, et préférentiellement comprise entre 200nm et 10 microns, ou entre 200nm et 1 micron. C'est notamment le cas lorsque le substrat final vise des applications dans le domaine de la photonique, qui requiert une couche diélectrique 4 épaisse, dont l'épaisseur est typiquement supérieure à 600nm et même atteindre 10 microns.

Le substrat final S comprend une couche mince 5, sur et en contact avec la couche diélectrique 4 du substrat support 1. La couche mince est usuellement en silicium monocristallin, mais il pourrait s'agir de tout autre matériau, semi-conducteur ou non, selon la nature du dispositif destiné à y être formé. Lorsque le substrat final S est destiné à recevoir des composants intégrés à semi-conducteur, la couche mince 5 peut être ainsi composée de silicium monocristallin, ou de tout autre matériau semi-conducteur tel que du germanium, du silicium germanium, du carbure de silicium.

Les composants intégrés à semi-conducteur peuvent notamment être de natures photoniques, tel des composants passifs ou actifs de type guide d'ondes, résonateur en anneau (« ring resonator » selon la terminologie anglo-saxonne) ou de type interféromètre de Mach-Zehnder. Ce type de dispositifs, notamment les commutateurs et les déphaseurs optiques, doivent pouvoir véhiculer efficacement une grande quantité de signal tout en respectant des spécifications de compacité, de faible consommation de puissance, limitation du phénomène de couplage électromagnétique, et de rapidité de commutation, ce qui peut être avantageusement procuré par des substrats avancés tels que le substrat final S.

Avantageusement, le dispositif photonique 51 (représenté à titre d'illustration sur la figure 4) forme un commutateur, un guide d'ondes, un déphaseur, un modulateur, un émetteur laser, un amplificateur, un coupleur directionnel, un filtre, et/ou un multiplexeur.

Lorsque le substrat final S est destiné à recevoir des filtres à onde acoustique de surface, la couche mince 5 peut être composée d'un matériau piézoélectrique et/ou ferroélectrique, tel que du tantalate de lithium ou du niobate de lithium. La couche mince 5 peut également comprendre des composants intégrés finis ou semi-finis, formés sur un substrat donneur et reportés sur le substrat support 1 au cours de la fabrication du substrat final S. D'une manière générale, la couche mince 5 peut présenter une épaisseur comprise entre 10nm et 10 microns.

### Préparation du substrat support

On présente maintenant un procédé de préparation du substrat support 1 représenté sur la figure 1. Dans une première étape, on fournit le substrat de base 3 présentant sur une face principale la couche de piégeage de charges 2. La fabrication de cette couche de piégeage 2, lorsqu'elle est en silicium polycristallin, peut être réalisée avec des équipements de dépôt standards dans l'industrie. Il peut ainsi s'agir d'un dépôt du type RPCVD (acronyme de l'expression anglo-saxonne « Remote Plasma enhanced Chemical Vapor Déposition » ou dépôt chimique en phase vapeur assisté par plasma déporté) ou encore du type PECVD (acronyme de l'expression anglo-saxonne « Plasma Enhanced Chemical Vapor Déposition » ou dépôt chimique en phase vapeur assisté par plasma). Il peut également s'agir d'un dépôt LPCVD (acronyme de l'expression anglo-saxonne « Low Pressure Chemical Vapor Déposition » ou dépôt chimique en phase vapeur à pression sous atmosphérique). Mais, comme on l'a vu précédemment, la formation de la couche de piégeage sur ou dans le substrat de base 3 peut être réalisée par bien d'autres manières, par exemple par implantation d'espèces lourdes ou par porosification d'une couche superficielle du substrat de base 3.

Optionnellement, on peut avoir prévu la formation d'une fine couche diélectrique sur le substrat de base 3, par exemple par oxydation ou dépôt d'une épaisseur d'oxyde, avant d'y former la couche de piégeage de charges 2.

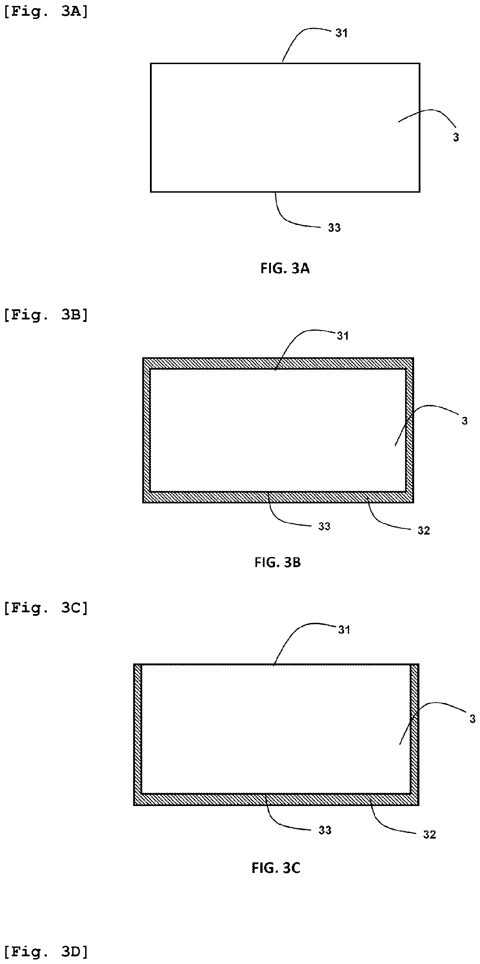

Dans le cas du mode de réalisation prévoyant une couche de compensation de la courbure, cette première étape comprend, avant la formation de la couche de piégeage, une première sous étape suivante visant à former une couche de compensation sur toutes les surfaces exposées du substrat de base (figure 3A et 3B). Pour les mêmes raisons de disponibilité et de coût citées auparavant, la couche de compensation 32 peut être en oxyde de silicium formé par une oxydation thermique du substrat de base 3 en silicium, par exemple réalisée à une température comprise entre 800 et 1100 °C.

Dans une sous étape suivante représentée sur la figure 3C, on élimine au moins en partie la couche de compensation 32 de la face avant 31, avant de former la couche de piégeage 2 et la couche diélectrique 4. Cette sous-étape peut notamment être menée par polissage de la face avant 31. On peut prévoir de préserver une portion de la couche de compensation 32 sur la face avant 31 du substrat de base afin de constituer la fine couche diélectrique sur laquelle sera formée la couche de piégeage de charge.

Les contraintes présentes dans la couche de compensation 32 sont équilibrées lorsque cette couche est présente sur chacune des faces principale 31 et arrière 33 du substrat de base 3. La sous-étape d'élimination de la couche de compensation 32 de la face principale 31 tout en conservant la couche 32 au moins sur la face arrière 33 conduit à briser cet équilibre et à courber le substrat de base 3. Ainsi, lorsque couche de compensation 32 présente une contrainte en compression, le substrat de base 3 présentera une courbure négative lui conférant une forme légèrement concave.

Ainsi, et à titre d'exemple, lorsque le substrat de base 3 est en silicium et présente une épaisseur conventionnelle de l'ordre de 650 microns, la conservation d'une couche de compensation 32 en oxyde de silicium thermique uniquement sur la face arrière 33 d'une épaisseur d'environ 600 nm générera une courbure concave de l'ordre de -110 µm. Cette courbure concave permettra de compenser au moins en partie la déformation apportée par la couche de piégeage et la couche diélectrique.

L'épaisseur de la couche de compensation 32 est ainsi déterminée selon les épaisseurs visées de la couche de piégeage de charge 2 et de la couche diélectrique 4 pour que le substrat support présente une courbure tolérée prédéterminée après la formation de ces couches. Cette courbure tolérée peut être au maximum de 100 microns (et préférentiellement au maximum de 60 microns ou de 40 microns) pour un substrat de 300mm de diamètre, cette valeur maximale permettant de manipuler le substrat support et de le traiter avec des équipements conventionnels. La couche de compensation 32 présente typiquement une épaisseur comprise entre 500 nm et 1000 nm.

La figure 3D présente le substrat support de ce mode de réalisation à l'issue de cette première étape, c'est-à-dire après la formation de la couche de piégeage de charge 2.

Dans une seconde étape du procédé de préparation du substrat support 1, et indépendamment du fait que le substrat de base soit muni ou non d'une couche de compensation, on forme la couche diélectrique 4 sur la couche de piégeage de charge 2. Selon un aspect important du procédé, la formation de la couche diélectrique 4 met simultanément en oeuvre le dépôt et la pulvérisation ionique (« sputtering » selon l'expression anglo-saxonne employée dans le métier) de cette couche diélectrique 4.

Une telle technique de formation la couche diélectrique peut être réalisée en disposant le substrat de base 3 muni de la couche de piégeage 2 et éventuellement de la couche de compensation 32 dans une chambre d'un équipement de dépôt du type HDP CVD (acronyme de l'expression anglo-saxonne « High Density Plasma Chemical Vapor Déposition » ou dépôt chimique en phase vapeur à haute densité de plasma).

Une telle chambre est munie d'une source plasma disposée dans une partie supérieure de la chambre, excité par une source RF (par exemple présentant une fréquence d'environ 13 MHz) afin d'y former un plasma d'où peuvent être extraits des électrons et des ions présents en très haute densité (de l'ordre de 10^10 à 10^12 par cm³). Le substrat introduit dans la chambre est disposé sur un support qui forme une seconde électrode reliée à une seconde source RF (par exemple présentant une fréquence d'environ 2 MHz), souvent désignée par l'expression « bias source » dans le domaine, permettant de projeter les ions et électrons sur la surface exposée du substrat, ce qui a pour effet de graver légèrement (pulvériser) cette surface. La première et la deuxième source sont activées à des puissances typiquement comprises entre 1000W et 10000W (pour un équipement destiné à recevoir un substrat se présentant sous la forme d'une plaquette circulaire de 300mm de diamètre). Des gaz précurseurs sont introduits dans la chambre pour les faire réagir entre eux au-dessus de la surface exposée du substrat et progressivement former sur celle-ci la couche diélectrique. La chambre est maintenue à une pression très basse, de l'ordre du mTorr ou de quelques dizaines de mTorr, à l'aide d'une pompe d'aspiration permettant de faire circuler et d'extraire de la chambre les gaz injectés et les espèces résiduels de la réaction. La chambre est également maintenue à relativement basse température, typiquement comprise entre 200°C et 450°C. Ainsi, pour former une couche d'oxyde de silicium, on introduit dans la chambre un gaz contenant du silicium, un gaz contenant de l'oxygène et un gaz inerte (argon ou hélium par exemple). En maîtrisant les paramètres de la chambre, et notamment les flux des gaz entrants et les puissances des sources, il est possible de maîtriser l'effet de dépôt et l'effet de pulvérisation qui se produisent simultanément au cours de la formation de la couche diélectrique dans la chambre, dans un ratio dépôt/pulvérisation compris entre 1 et 10, préférentiellement entre 2 et 5. Cet effet combiné tend à compenser la topologie éventuellement présente à la surface du substrat et à former une couche particulièrement uniforme et lisse. On rappelle à ce propos que pour obtenir une surface qui puisse être assemblée par adhésion moléculaire, celle-ci doit présenter une rugosité inférieure à 0,5 nm RMS (c'est-à-dire en valeur quadratique moyenne) sur un champ de mesure de 10 microns par 10 microns. Et de manière particulièrement surprenante, notamment pour une couche de diélectrique relativement épaisse, supérieure à 200nm, un tel procédé de formation permet d'atteindre cette exigence de faible rugosité. On rappelle en effet que dans l'emploi usuel d'un équipement de dépôt du type HDP CVD, la couche formée vise à remplir des motifs topologiques présentant un facteur de forme important et que ces dépôts sont nécessairement suivis d'une étape de polissage. Il n'était donc aucunement attendu que la formation de la couche diélectrique sur la couche de piégeage de charge conduise à constituer une couche dont la rugosité de surface soit aussi faible que 0,5 nm RMS sur un champ de mesure de 10 microns par 10 microns.

Revenant au procédé de préparation du substrat support 1, celui-ci comprend donc la formation de la couche diélectrique 4 en mettant en oeuvre une telle technique de dépôt et de pulvérisation ionique simultanés. Dans un mode de mise en oeuvre privilégié, la couche diélectrique 4 est constituée d'oxyde de silicium. Dans ce cas, et pour un substrat support 1 présentant une dimension de 300mm, les gaz introduits dans la chambre peuvent comprendre du silane (SiH4), de l'oxygène et de l'argon (ou un autre gaz neutre tel que de l'hélium), dans des débits massiques compris entre 20 et 80 sccm (centimètre cube standard par minute). La puissance des sources peut être choisie entre 1000W et 5000W. la couche diélectrique 4 est formée à une température comprise entre 300°C et 450°C, préférentiellement entre 350°C et 400°C, et la pression dans la chambre est maintenue sous la pression atmosphérique, et préférentiellement sous 5mTorr. On pourra contrôler ces paramètres pour définir un ratio dépôt/pulvérisation préférentiellement compris entre 2 et 5.

On pourra bien entendu choisir de former une couche diélectrique 4 autre qu'une couche d'oxyde de silicium, par exemple une couche de nitrure de silicium ou d'oxynitrure de silicium, en modifiant la nature des gaz introduits (du N₂, NH₃ ou N₂O à la place de l'oxygène pris en exemple) dans la chambre et en ajustant les autres paramètres du procédé.

On peut notamment maîtriser les flux de gaz entrant dans la chambre pour former une couche diélectrique 4 comprenant au moins une alternance formée d'une première couche élémentaire en oxyde de silicium et d'une seconde couche élémentaire en oxynitrure de silicium ou en nitrure de silicium. Ainsi, dans un mode de mise en oeuvre particulier, on peut prévoir d'enfouir une couche d'oxynitrure ou de nitrure de silicium dans l'épaisseur de la couche diélectrique principalement formée d'oxyde de silicium. On forme de la sorte une couche barrière intégrée à la couche diélectrique 4, cette barrière pouvant notamment permettre de limiter, lors des étapes suivantes de fabrication du substrat final, la diffusion de certaines espèces, telles que de l'hydrogène, dans toute la profondeur de la couche diélectrique. Avantageusement, cette barrière en oxynitrure ou en nitrure de silicium est disposée à proximité de la face libre de la couche diélectrique, par exemple sous une couche superficielle de 10nm à 50nm d'oxyde de silicium.

Dans tous les cas, et quelle que soit la nature exacte de la couche diélectrique 4, on maintiendra la chambre de dépôt en fonctionnement suffisamment longtemps pour former une couche diélectrique 4 d'épaisseur choisie. Dans le cadre de la présente description, cette épaisseur est relativement épaisse, par exemple supérieure à 200nm et avantageusement comprise entre 200nm et 1 micron ou même 10 microns. Il peut s'agir à titre d'exemple complémentaire de former une couche diélectrique 4 de 400nm d'épaisseur.

Les essais menés par la demanderesse ont montré que la formation d'une telle couche en oxyde de silicium de 400nm sur une couche de piégeage 2 en silicium polycristallin et se présentant sous la forme d'une plaquette circulaire de 300mm de diamètre, permettait de préparer un substrat support 1 ayant des propriétés particulièrement adaptées à la formation du substrat final S.

Ainsi, et de manière particulièrement inattendue comme cela a été indiqué précédemment, la surface exposée de ce substrat support 1, ie la face libre de la couche diélectrique 4 en oxyde de silicium, présentait une rugosité de surface inférieure à 2 Angstrom RMS (valeur quadratique moyenne) sur des champs de mesure de 10 microns par 10 microns et sur des champs de mesure de 30 microns par 30 microns. Cette rugosité est similaire à celle obtenue en oxydant une couche de piégeage en silicium polycristallin, après que celle-ci ait subi une étape de polissage pour en rectifier la rugosité. Elle est suffisamment faible pour être compatible avec une étape d'assemblage par adhésion moléculaire. Le procédé proposé de formation de la couche diélectrique 4 est ainsi très avantageux en ce qu'il permet d'éviter cette étape de polissage, ce qui simplifie le procédé de préparation du substrat support 1.

De plus, l'interface entre la couche diélectrique 4 en oxyde de silicium et la couche de piégeage en silicium polycristallin présentait une rugosité inférieure à 2 Angstrom RMS (pour les mêmes champs de mesure de 10 microns par 10 microns et de 30 microns par 30 microns) alors qu'une couche diélectrique en oxyde de silicium de même épaisseur de 400nm formée par oxydation de la couche de piégeage en silicium polycristallin présentait une rugosité de l'ordre de 50 Angstrom RMS.

Le procédé de formation de la couche diélectrique 4 est réalisé à relativement basse température, inférieure à 400°C, et autour de 380°C pour la formation d'une couche diélectrique en oxyde de silicium. On évite de la sorte de recristalliser la couche de piégeage de charge 2 et de faire disparaître les pièges électriques, ce qui pourrait se produire lorsque cette couche est exposée à de plus hautes températures, par ré-épitaxie en phase solide de cette couche.

De plus, la formation de la couche diélectrique 4 selon la technique proposée induit une déformation du substrat support 1 bien moindre (de l'ordre de 100 microns sur un substrat support 1 de 300mm muni d'une couche d'oxyde de silicium de 400nm) que celle induite en oxydant une couche de piégeage en silicium polycristallin (de l'ordre de 150 microns). A nouveau, cette propriété rend un substrat support 1 obtenu par un procédé selon l'invention bien plus compatible avec une étape d'assemblage par adhésion moléculaire. Cette propriété est encore améliorée lorsque le substrat support est muni d'une couche de compensation, l'épaisseur de cette couche pouvant être choisie pour justement compenser la déformation apportée par la couche diélectrique 4 et, dans une moindre mesure, par la couche de piégeage de charges. Ce mode de réalisation est notamment utile lorsque la couche diélectrique présente une épaisseur importante, supérieure à 600nm.

On note que le procédé de préparation du substrat support 1 peut également incorporer une étape de recuit de la couche diélectrique 4. Ce recuit, dit de dégazage ou de densification, est avantageusement mené dans une atmosphère neutre. Il est réalisé à une température excédant la température de dépôt de la couche diélectrique 4, et de préférence inférieure à 950°C, pendant une durée relativement courte inférieure à 1h, comme par exemple 30 minutes. On choisira la durée et la température de ce recuit pour éviter, ou au moins pour limiter, la recristallisation de la couche de piégeage 2. Cette étape de recuit peut affecter la courbure du substrat support, et il sera pris en compte pour déterminer l'épaisseur de la couche de compensation.

### Fabrication du substrat final

On dispose à l'issue du procédé de préparation qui vient d'être présenté d'un substrat support 1 présentant au moins une couche de piégeage 2 et une couche diélectrique 4 successivement disposés sur le substrat de base 3. Le substrat support peut également inclure une couche de compensation 32 permettant de maîtriser la courbure de ce substrat inférieure ou égale à 100 microns, par exemple comprise entre 100 et 60 microns, même en présence d'une couche diélectrique épaisse, par exemple de 600 nm.

Comme on l'a déjà mentionné, le substrat support 1 a pour vocation de recevoir, par report, une couche mince 5 et former ainsi un substrat final S. Le substrat support 1 présente des propriétés adaptées (en termes de rugosité de surface et de déformation notamment) pour recevoir une telle couche mince 5.

Comme cela est bien connu en soi, ce transfert est usuellement réalisé en assemblant une face libre d'un substrat donneur au substrat support 1, préférentiellement par adhésion moléculaire. La couche diélectrique 4 ayant été préalablement formé sur le substrat support 1, il n'est pas nécessaire que le substrat donneur soit lui-même muni d'une telle couche diélectrique. On peut néanmoins prévoir que ce substrat donneur soit muni d'une fine épaisseur de diélectrique (par exemple inférieure à 150nm), mais dans tous les cas cette épaisseur sera toujours bien inférieure à l'épaisseur de la couche diélectrique 4 de la structure finale S, puisqu'une partie de cette épaisseur sera fournie par la couche diélectrique 4 formée sur le substrat support 1. De préférence donc, le substrat donneur est dépourvu de toute couche superficielle diélectrique intentionnellement formée. La nature du substrat donneur est choisie selon la nature désirée de la couche mince 5, comme celle-ci a déjà été décrite dans une section antérieure de cet exposé. Il peut donc s'agir d'un substrat formé d'un semi-conducteur monocristallin, par exemple de silicium, ou d'un substrat formé d'un matériau piézo-électrique ou comprenant une couche superficielle d'un tel matériau piézo-électrique.

Après cette étape d'assemblage, le substrat donneur est réduit en épaisseur pour former la couche mince 5. Cette étape de réduction peut être réalisée par amincissement mécanique ou chimique, mais dans le cadre de la présente description et pour tirer tout le profit des propriétés avantageuses du substrat support 1, la réduction d'épaisseur du substrat donneur est réalisée par fracture au niveau d'un plan de fragilisation préalablement introduit, par exemple selon les principes de la technologie Smart Cut^{™}, comme cela a été exposé en introduction de cette demande. Ce plan de fragilisation définit, avec la surface libre du substrat donneur, la couche mince 5.

On note que le substrat donneur ne présentant préférentiellement pas de couche diélectrique superficielle (ou présentant une couche d'épaisseur relativement réduite), la dose et l'énergie des espèces implantées pour former le plan de fragilisation peuvent être maintenues à des valeurs raisonnables, même lorsque le substrat final S présente une couche diélectrique 4 épaisse, de 200nm ou plus.

Le transfert de la couche mince ne modifie pas l'équilibre de contrainte, si bien qu'à ce stade le substrat final présente une courbure très similaire à celle du substrat support.

Après cette étape d'amincissement ou, préférentiellement, de fracture, des étapes de finition de la couche mince 5, telle qu'une étape de polissage, un traitement thermique sous atmosphère réductrice ou neutre, une oxydation sacrificielle peuvent être enchaînées à l'étape de réduction d'épaisseur.

Lorsque le substrat donneur est un simple substrat, c'est-à-dire qu'il ne comprend pas de dispositif intégré, on forme ainsi un substrat final S du type « sur isolant », dans lequel la couche mince 5 est une couche de matériau vierge, comprenant le substrat support 1 conforme à l'invention. Ce substrat final S peut être alors utilisé pour la formation de dispositifs intégrés ou photoniques, comme cela a été illustré à la figure 4. Lorsque le substrat donneur a été préalablement traité pour former à sa surface des dispositifs intégrés, on dispose à l'issue de ce procédé une couche mince 5 qui comprend ces dispositifs.

Bien entendu l'invention n'est pas limitée aux modes de mise en oeuvre décrit et on peut y apporter des variantes de réalisation sans sortir du cadre de l'invention tel que défini par les revendications.

## Revendications

1. Procédé de report d'une couche mince (5) sur un substrat support (1) comprenant les étapes suivantes :
- préparer un substrat support (1) à l'aide d'un procédé de préparation comprenant la fourniture d'un substrat de base (3) présentant, sur une face principale, une couche de piégeage de charges (2) et la formation d'une couche diélectrique (4) présentant une épaisseur supérieure à 200nm sur la couche de piégeage de charges (2), la formation de la couche diélectrique (4) mettant simultanément en oeuvre le dépôt et la pulvérisation ionique de la couche diélectrique ;
- assembler, par adhésion moléculaire et sans préparer la face libre de la couche diélectrique (4) par polissage, un substrat donneur à la couche diélectrique (4) du substrat support (1), le substrat donneur présentant un plan de fragilisation définissant la couche mince (5) ;
- fracturer le substrat donneur au niveau du plan de fragilisation pour libérer la couche mince (5) et la reporter sur le substrat support (1).

2. Procédé selon la revendication précédente dans lequel le procédé de préparation comprend la formation d'une couche de compensation de courbure (32) sur une face arrière du substrat de base (3), opposée à la face principale.

3. Procédé selon la revendication précédente dans lequel la couche de compensation de courbure (32) présente une épaisseur comprise entre 500 nm et 1000nm.

4. Procédé selon l'une des revendications précédentes dans lequel le substrat de base (3) est un substrat de silicium monocristallin présentant une résistivité supérieure à 600 ohm.cm.

5. Procédé selon l'une des revendications précédentes dans lequel la couche de piégeage de charges (2) comprend du silicium polycristallin.

6. Procédé selon l'une des revendications précédentes dans lequel la couche de piégeage de charges (2) comprend du carbone.

7. Procédé selon l'une des revendications précédentes dans lequel la couche de piégeage de charges (2) présente une épaisseur comprise entre 1 micron et 20 microns.

8. Procédé selon l'une des revendications précédentes dans lequel la couche diélectrique (4) est constituée d'oxyde de silicium.

9. Procédé selon l'une des revendications précédentes dans lequel la couche diélectrique (4) comprend une couche barrière en nitrure de silicium ou en oxynitrure de silicium.

10. Procédé selon l'une des revendications précédentes dans lequel la couche diélectrique (4) présente une épaisseur comprise entre 200nm et 10 microns, et préférentiellement entre 600nm et 10 microns.

11. Procédé selon l'une des revendications précédentes dans lequel le ratio dépôt/pulvérisation est compris entre 1 et 10, préférentiellement entre 2 et 5.

12. Procédé selon l'une des revendications précédentes dans lequel la couche diélectrique (4) est formée à une température comprise entre 300°C et 450°C, préférentiellement entre 350°C et 400°C.

13. Procédé selon l'une des revendications précédentes dans lequel la couche diélectrique (4) est formée dans une atmosphère présentant une pression inférieure à la pression atmosphérique.

14. Procédé selon l'une des revendications précédentes comprenant en outre un recuit de la couche diélectrique (4) dans une atmosphère neutre et à une température excédant la température de formation de la couche diélectrique, préférentiellement inférieure à 950°C.

15. Procédé selon l'une des revendications précédentes dans lequel la face libre de la couche diélectrique (4) présente une rugosité inférieure à 0,5 nm en valeur quadratique moyenne sur un champ de mesure de 10 microns par 10 microns.

16. Procédé selon l'une des revendications précédentes dans lequel le substrat donneur est dépourvu de toute couche superficielle diélectrique.

## Patentansprüche

1. Verfahren zum Übertragen einer Dünnschicht (5) auf ein Trägersubstrat (1), umfassend die folgenden Schritte:
- Herstellen eines Trägersubstrats (1) unter Verwendung eines Herstellungsverfahrens, umfassend das Bereitstellen eines Basissubstrats (3), das eine Ladungseinfangschicht (2) auf einer Hauptfläche aufweist, und das Ausbilden einer dielektrischen Schicht (4), die eine größeren Dicke als 200 nm aufweist, auf der Ladungseinfangschicht (2), wobei das Ausbilden der dielektrischen Schicht (4) gleichzeitig die Abscheidung und die lonenzerstäubung der dielektrischen Schicht durchführt;
- Verbinden, durch molekulare Adhäsion und ohne Herstellen der freien Fläche der dielektrischen Schicht (4) durch Polieren, eines Donorsubstrats mit der dielektrischen Schicht (4) des Trägersubstrats (1), wobei das Donorsubstrat eine Schwächungsebene aufweist, die die Dünnschicht (5) definiert;
- Brechen des Donorsubstrats an der Schwächungsebene, um die Dünnschicht (5) freizugeben und sie auf das Trägersubstrat (1) zu übertragen.

2. Verfahren nach dem vorstehenden Anspruch, wobei das Herstellungsverfahren das Ausbilden einer Krümmungskompensationsschicht (32) auf einer Rückseite des Basissubstrats (3), die der Hauptfläche gegenüberliegt, umfasst.

3. Verfahren nach dem vorstehenden Anspruch, wobei die Krümmungskompensationsschicht (32) eine Dicke zwischen 500 nm und 1000 nm aufweist.

4. Verfahren nach einem der vorstehenden Ansprüche, wobei das Basissubstrat (3) ein monokristallines Siliziumsubstrat, das einen spezifischen Widerstand von mehr als 600 Ohm.cm aufweist, ist.

5. Verfahren nach einem der vorstehenden Ansprüche, wobei die Ladungseinfangschicht (2) polykristallines Silizium umfasst.

6. Verfahren nach einem der vorstehenden Ansprüche, wobei die Ladungseinfangschicht (2) Kohlenstoff umfasst.

7. Verfahren nach einem der vorstehenden Ansprüche, wobei die Ladungseinfangschicht (2) eine Dicke zwischen 1 Mikrometer und 20 Mikrometern aufweist.

8. Verfahren nach einem der vorstehenden Ansprüche, wobei die dielektrische Schicht (4) aus Siliziumoxid besteht.

9. Verfahren nach einem der vorstehenden Ansprüche, wobei die dielektrische Schicht (4) eine Sperrschicht aus Siliziumnitrid oder aus Siliziumoxinitrid umfasst.

10. Verfahren nach einem der vorstehenden Ansprüche, wobei die dielektrische Schicht (4) eine Dicke zwischen 200 nm und 10 Mikrometern und vorzugsweise zwischen 600 nm und 10 Mikrometern aufweist.

11. Verfahren nach einem der vorstehenden Ansprüche, wobei das Verhältnis von Abscheidung/Pulverisierung zwischen 1 und 10, vorzugsweise zwischen 2 und 5, liegt.

12. Verfahren nach einem der vorstehenden Ansprüche, wobei die dielektrische Schicht (4) bei einer Temperatur zwischen 300 °C und 450 °C, vorzugsweise zwischen 350 °C und 400 °C, ausgebildet wird.

13. Verfahren nach einem der vorstehenden Ansprüche, wobei die dielektrische Schicht (4) in einer Atmosphäre ausgebildet wird, die einen Druck, der niedriger als der Atmosphärendruck ist, aufweist.

14. Verfahren nach einem der vorstehenden Ansprüche, ferner umfassend ein Glühen der dielektrischen Schicht (4) in einer neutralen Atmosphäre und bei einer Temperatur, die die Temperatur zum Ausbilden der dielektrischen Schicht übersteigt, von vorzugsweise weniger als 950 °C.

15. Verfahren nach einem der vorstehenden Ansprüche, wobei die freie Fläche der dielektrischen Schicht (4) eine Rauigkeit von weniger als 0,5 nm im quadratischen Mittelwert auf einem Messbereich von 10 Mikrometern mal 10 Mikrometern aufweist.

16. Verfahren nach einem der vorstehenden Ansprüche, wobei das Donorsubstrat frei von jeglicher dielektrischen Schicht ist.

## Claims

1. Method for transferring a thin film (5) onto a carrier substrate (1), comprising the following steps:
- preparing a carrier substrate (1) by means of a preparation process comprising providing a base substrate (3) having, on a main face, a charge-trapping layer (2) and forming a dielectric layer (4) having a thickness greater than 200 nm on the charge-trapping layer (2), the formation of the dielectric layer (4) simultaneously implementing the deposition and ion sputtering of the dielectric layer;
- joining, by molecular bonding and without preparing the free face of the dielectric layer (4) by polishing, a donor substrate to the dielectric layer (4) of the carrier substrate (1), the donor substrate having a fragile plane defining the thin film (5);
- splitting the donor substrate at the fragile plane to release the thin film (5) and transfer it to the carrier substrate (1).

2. Method according to the preceding claim, wherein the preparation process comprises forming a curvature compensation layer (32) on a rear face of the base substrate (3), opposite the main face.

3. Method according to the preceding claim, wherein the curvature compensation layer (32) has a thickness of between 500 nm and 1000 nm.

4. Method according to any of the preceding claims, wherein the base substrate (3) is a monocrystalline silicon substrate with a resistivity greater than 600 ohm-cm.

5. Method according to any of the preceding claims, wherein the charge-trapping layer (2) comprises polycrystalline silicon.

6. Method according to any of the preceding claims, wherein the charge-trapping layer (2) comprises carbon.

7. Method according to any of the preceding claims, wherein the charge-trapping layer (2) has a thickness of between 1 micron and 20 microns.

8. Method according to any of the preceding claims, wherein the dielectric layer (4) consists of silicon oxide.

9. Method according to any of the preceding claims, wherein the dielectric layer (4) comprises a barrier layer consisting of silicon nitride or silicon oxynitride.

10. Method according to any of the preceding claims, wherein the dielectric layer (4) has a thickness of between 200 nm and 10 microns, and preferably between 600 nm and 10 microns.

11. Method according to any of the preceding claims, wherein the deposition/sputtering ratio is between 1 and 10, preferably between 2 and 5.

12. Method according to any of the preceding claims, wherein the dielectric layer (4) is formed at a temperature of between 300°C and 450°C, preferably between 350°C and 400°C.

13. Method according to any of the preceding claims, wherein the dielectric layer (4) is formed in an atmosphere having a pressure lower than the atmospheric pressure.

14. Method according to any of the preceding claims, further comprising annealing the dielectric layer (4) in a neutral atmosphere and at a temperature which exceeds the dielectric layer formation temperature, preferably below 950°C.

15. Method according to any of the preceding claims, wherein the free face of the dielectric layer (4) has a roughness of less than 0.5 nm in root-mean-square value over a measurement field of 10 microns by 10 microns.

16. Method according to any of the preceding claims, wherein the donor substrate is devoid of any dielectric surface layer.
